# EUROPÄISCHE PATENTANMELDUNG

(11) **EP 2 045 841 A1**
(43) Veröffentlichungstag der Anmeldung: **08.04.2009**
(21) Anmeldenummer: 08012361.5
(22) Anmeldetag: 09.07.2008
(51) Int. Cl.: H01L 25/07

(54) **Leistungshalbleitermodul mit Verbindungseinrichtungen**

(30) Priorität: 26.07.2007 DE 102007034847
(71) Anmelder: SEMIKRON Elektronik GmbH & Co. KG, 90431 Nürnberg (DE)
(72) Erfinder: Kroneder, Christian, 90596 Schwanstetten (DE)

(57) **Zusammenfassung**

Die Erfindung beschreibt ein Leistungshalbleitermodul mit einem Gehäuse mit ersten Verbindungseinrichtungen zur Anordnung auf einem externen Kühlbauteil, mindestens einem Substratträger mit einer hierauf ausgebildeten leistungselektronischen Schaltungsanordnungen und von dieser ausgehenden elektrischen Anschlusselementen zu zweiten Verbindungseinrichtungen zur Verbindung mit externen Stromleitungen, wobei die ersten und / oder die zweiten Verbindungseinrichtungen ausgebildet sind als im wesentlichen hohlzylinderförmige metallische Druckgussformteile, die spritztechnisch mit dem Gehäuse verbunden sind.

## Beschreibung

Die Erfindung beschreibt ein Leistungshalbleitermodul mit einem Gehäuse, mindestens einem vorzugsweise in einer Aussparung des Gehäuses angeordneten und von dem Gehäuse seitlich umschlossenen Substratträger mit einer hierauf ausgebildeten leistungselektronischen Schaltungsanordnung und von dieser ausgehenden elektrischen Anschlusselementen.

Beispielhaft ist in der DE 101 00 460 A1 ein Leistungshalbleitermodul der genannten Art offenbart, wie es in seiner Grundausprägung seit langem bekannt ist. Derartige Leistungshalbleitermodule gemäß dem Stand der Technik weisen einen Substratträger auf, der den unteren Abschluss des Leistungshalbleitermoduls bildet. Das Isolierstoffgehäuse überragt hierbei diesen Substratträger an seinen Längsseiten geringfügig um ihn zu umschließen. Derartige Substratträger sind häufig ausgebildet als ein flächiger Metallformkörper, vorzugsweise aus Kupfer. Hierdurch ist ein geringer Wärmewiderstand bei wirksamer Wärmespreizung für den Wärmetransport von der leistungselektronischen Schaltungsanordnung zu einem Kühlbauteil gegeben.

Gemäß dem Stand der Technik ist weiterhin bekannt, dass der Substratträger mit dem Gehäuse verklebt ist, um bei einer Befüllung des Gehäuses mit einem zu diesem Zeitpunkt flüssigen Isolierstoff, beispielhaft einem Silikonkautschuk, ein Ausfließen diese Silikonkautschuks zu verhindern. Weiterhin ist das Gehäuse mittels metallischer Nietverbindungen mit dem Substratträger verbunden. Diese Nietverbindungen sind als Hohlkörper mit einer durchgehenden Ausnehmung ausgebildet um ebenso eine Befestigung des Leistungshalbleitermoduls auf einem Kühlbauteil mittels einer Schraubverbindung zu ermöglichen. Gemäß dem Stand der Technik sind diese Nietverbindungen als Messingnieten ausgebildet, da diese auf Grund des Bleianteils des Messings eine gewisse Verformung ermöglichen und somit eine Nietverbindung erst möglich machen.

Auf dem Substratträger selbst ist isoliert von diesem die Schaltungsanordnung des Leistungshalbleitermoduls angeordnet. Hierbei sind verschiedene Schaltungsanordnungen mit Leistungstransistoren, Leistungsdioden und / oder Leistungsthyristoren bekannt. Die Schaltungsanordnung ist mittels isolierender Substrate, beispielhaft DCB- (direct copper bonding) Substrate, von dem Substratträger isoliert.

Weiterhin dem Stand der Technik zuzuordnen sind verschieden ausgestaltete Anschlusselemente für Last- und Hilfsanschlüsse. Hierbei sind verschiedene Verbindungstechnologien dieser Anschlusselemente mit dem Substrat oder den Leistungshalbleiterbauelementen der Schaltungsanordnung bekannt. Besonders bevorzugt sind hierbei Lötverbindungen, Druckkontaktverbindungen und / oder Drucksinterverbindungen. Zur externen Verbindung weisen vorzugsweise die Lastanschlusselemente Verbindungseinrichtung zur Schraubverbindung auf. Diese sind häufig ausbildet als in das Gehäuse lose eingebettete Schraubenmuttern mit Innengewinde und hierüber angeordnete Abschnitte der Anschlusselemente mit einer zum Innengewinde fluchtenden durchgehenden Ausnehmung.

Der Erfindung liegt somit die Aufgabe zugrunde, ein Leistungshalbleitermodul mit Verbindungseinrichtungen zu einem Kühlbauteil und / oder externen Stromleitungen vorzustellen, die bleifrei ausgebildet sind und zudem einem kostengünstigen und automatisierbaren Herstellungsverfahren zugänglich.

Diese Aufgabe wird erfindungsgemäß gelöst, durch einen Gegenstand mit den Merkmalen des Anspruchs 1. Bevorzugte Ausführungsformen sind in den Unteransprüchen beschrieben.

Den Ausgangspunkt der Erfindung bildet ein Leistungshalbleitermodul mit einem Gehäuse, mindestens einem vorzugsweise in einer Aussparung des Gehäuses angeordneten und von dem Gehäuse seitlich, vorzugsweise allseits, umschlossenen Substratträger. Auf diesem Substratträger ist eine leistungselektronische Schaltungsanordnung ausgebildet, von welcher elektrische Anschlusselemente für Last-und Hilfsanschlüsse ausgehen. Der Substratträger bildet somit eine dem Kühlbauteil zugewandte Außenseite oder den Teil einer Außenseite des Leistungshalbleitermoduls.

Erfindungsgemäß weist hierbei das Gehäuse erste und / oder zweite Verbindungseinrichtungen auf. Diese ersten und / oder die zweiten Verbindungseinrichtungen sind jeweils ausgebildet als im Wesentlichen hohlzylinderförmige metallische Druckgussformteile, vorzugsweise aus Aluminium- oder Zinkdruckguss.

Die ersten Verbindungseinrichtungen dienen der Anordnung des Leistungshalbleitermoduls auf und Verbindung zu einem externen Kühlbauteil. Hierzu weist das Gehäuse des Leistungshalbleitermoduls Ausnehmungen auf, in denen jeweils eine Schraubverbindung zum Kühlbauteil anordenbar ist. Diese stellt eine mechanische Verbindung dar. Da das Gehäuse gemäß dem Stand der Technik aus einem Kunststoff besteht ist es vorteilhaft, diese Ausnehmung durch einen Metallformkörper zu verstärken. Die ersten Verbindungseinrichtungen bilden diese verstärkenden Metallformkörper aus. Es ist hierbei bevorzugt, wenn das Druckgussformteil der ersten Verbindungseinrichtung eine glatte Innenfläche zur Durchführung einer Schraube aufweist. Das Druckgussformteil ist hierbei derart im Gehäuse angeordnet, dass die Schraube auf einer ersten Planfläche des ersten Druckgussformteil aufliegt und die zweite Fläche auf dem Kühlbauteil aufliegt oder geringfügig hiervon beabstandet ist.

Die zweiten Verbindungseinrichtungen dienen der elektrischen Verbindung der modulinternen Anschlusselemente mit externen Stromleitungen. Von der Schaltungsanordnung auf dem Substratträger reichen die elektrischen Anschlusselemente, die vorzugsweise als flächige, bandartige und in Stanz- Biegetechnik hergestellte Metallformkörper ausgebildet sind, zu den zweiten Verbindungseinrichtungen.

Das Druckgussformteil der zweiten Verbindungseinrichtung ist hierbei vorzugsweise im Deckel des Leistungshalbleitermoduls angeordnet und weist ein Innengewinde auf. Hiermit ist es möglich, die Schraubenmuttern, die in hierfür vorgesehenen Aussparungen des Gehäuses von Leistungshalbleitermodulen gemäß dem Stand der Technik angeordnet sind, bei gleicher Funktion zu ersetzen. Das jeweils einer zweiten Verbindungseinrichtung zugeordnete Lastanschlusselement ist derart im Leistungshalbleitermodul angeordnet, dass ein Abschnitt dieses Lastanschlusselements, der eine durchgehende, vorzugsweise langlochartige Ausnehmung aufweist, mit dem Innengewinde das Druckgussformteil der zweiten Verbindungseinrichtung fluchtet. Somit kann bei Verwendung des Leistungshalbleitermoduls die Schraubverbindung von dem Lastanschlusselement zu einer externen Stromleitung einfach hergestellt werden.

Die erfindungsgemäßen ersten und / oder zweiten Druckgussformteile sind spritztechnisch mit dem Gehäuse verbunden. Hierzu ist es vorteilhaft, wenn das jeweilige Druckgussformteil an seinem Außenzylinder Fortsätze aufweist. Hierdurch wird die Verbindung mit dem Kunststoff des Gehäuses verbessert. Für das erste Druckgussformteil ist es weiterhin bevorzugt, wenn diese Fortsätze rotationssymmetrisch um die Hochachse des Druckgussformteils ausgebildet sind. Für das zweite Druckgussformteil ist es vorteilhaft, wenn diese Fortsätze nasenartig ausgebildet sind, um ein Verdrehen im Gehäuse zu verhindern.

Es kann weiterhin besonders bevorzugt sein, wenn der Substratträger in seiner Funktionalität durch das Substrat selbst ersetzt wird. Hierbei bildet das Substrat die Begrenzung des Leistungshalbleitermoduls und weist seinerseits die notwendigen Ausnehmungen für die Nietverbindung auf.

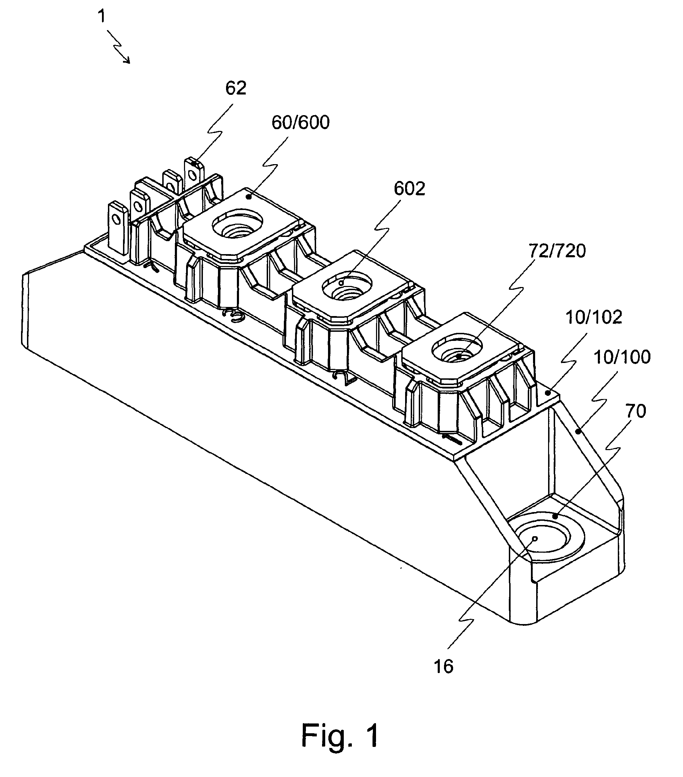

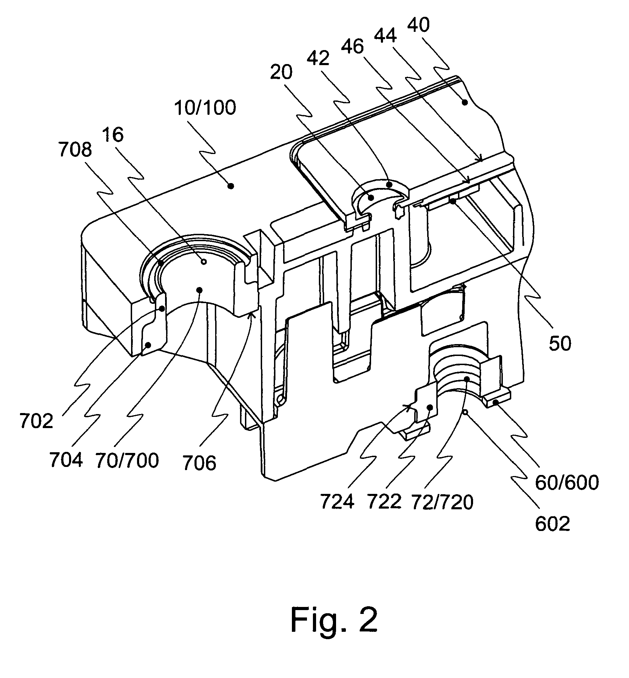

Besonders bevorzugte Weiterbildungen dieses Halbleiterbauelements sind in der jeweiligen Beschreibung der Ausführungsbeispiele genannt. Die erfinderische Lösung wird zudem an Hand der Ausführungsbeispiele und der Fig. 1 und 2 weiter erläutert.

Fig. 1 zeigt ein erfindungsgemäßes Leistungshalbleitermodul in dreidimensionaler Ansicht.

Fig. 2 zeigt einen Ausschnitt eines Leistungshalbleitermoduls gemäß Fig. im Längsschnitt.

Fig. 1 zeigt ein erfindungsgemäßes Leistungshalbleitermodul (1) in dreidimensionaler Ansicht. Das Leistungshalbleitermodul (1) besteht hierbei aus einem zweiteiligen Kunststoffgehäuse (10), aus einem bis über 150°C temperaturstabilen Kunststoff, mit einem Grundkörper (110) und einem Deckel (102), wobei diese vorteilhafterweise mittels einer Schnapp- Rast- Verbindung zueinander angeordnet und miteinander verbunden sind. Der Grundkörper (10) weist zwei Ausnehmungen (16) zur Schraubverbindung mit einem nicht dargestellten Kühlbauteil auf. Diese Ausnehmungen (16) weisen erste als Druckgussformteile (70) ausgebildete Verbindungseinrichtungen auf, die spritztechnisch mit dem Grundkörper (100) des Gehäuses (10) verbunden sind. Diese Druckgussformteile (70) bestehen aus Aluminium- oder Zinkdruckguss und weisen keinen Bleianteil im Metall auf.

Weiterhin dargestellt sind die Last- (60) und Hilfsanschlusselemente (62) des Leistungshalbleitermoduls (1). Die Hilfsanschlusselemente (62) sind hierbei mit Steckverbindungen ausgebildet, während die Lastanschlusselemente (60) mit Schraubverbindungen ausgebildet sind. Die Lastanschlusselemente (60) verbinden die leistungselektronische Schaltungsanordnung im Inneren des Leistungshalbleitermoduls (1) mit den zweiten Verbindungseinrichtungen (72). Hierzu sind die Lastanschlusselement (60) als flächige Metallformkörper ausgebildet, wobei diese in einem Abschnitt (600) an der zugeordneten Verbindungseinrichtung (72) eine langlochartige durchgehende Ausnehmung (602) aufweisen zur Durchführung einer Schraube und somit zur Schraubverbindung einer externen Stromleitung mit dem Lastanschlusselement (60) mittels der zweiten Verbindungseinrichtung (72). Diese ist hierbei ausgebildet als Druckgussformteil mit einem Innengewinde an ihrem Innenzylinder (720) und ist spritztechnisch mit dem Deckel (102) des Gehäuses (10) des Leistungshalbleitermoduls (1) verbunden.

Fig. 2 zeigt einen Ausschnitt eine Leistungshalbleitermoduls (1) gemäß Fig. 1 im Längsschnitt. Dargestellt ist hierbei das Gehäuse (10) des Leistungshalbleitermoduls (1), sowie ein hiervon umschlossener und mittels Nietverbindungen (20, 42) verbundener Substratträger (40). Dieser weist an seiner ersten inneren Hauptfläche (44) und elektrisch isoliert angeordnet die leistungselektronische Schaltungsanordnung (50) auf. Von dieser gehen nicht dargestellt Hilfs- und Lastanschlusselemente (60) aus und reichen zur parallelen Oberfläche des Leistungshalbleitermoduls (1). Die äußere Hauptfläche (46) des Substratträgers (40) bildet die Kontaktfläche zu einem Kühlbauteil.

Die erste im Wesentlichen hohlzylinderförmig ausgebildete Verbindungseinrichtung (70) ist in den Grundkörper (100) des Gehäuses (10) eingespritzt. Zur haltbaren Verbindung mit diesem Grundkörper (100) weist das Druckgussformteil (70) an seinem Außenzylinder (702) Fortsätze (704) auf, die rotationssymmetrisch um die Hochachse des Druckgussformteils (70) ausgebildet sind. An seinem Innenzylinder (700) weist das Druckgussformteil (70) der ersten Verbindungseinrichtung eine glatte Oberfläche auf.

Die zweite ebenfalls im Wesentlichen hohlzylinderförmig ausgebildete Verbindungseinrichtung (72) ist in den Deckel (100) des Gehäuses (10) eingespritzt. Zur haltbaren Verbindung mit diesem Deckel (102) weist das Druckgussformteil (72) an seinem Außenzylinder (722) Fortsätze (724) auf, die als Nasen vorzugsweise um die Hochachse des Druckgussformteils (70) herum angeordnet ausgebildet sind. An seinem Innenzylinder (720) weist das Druckgussformteil (72) der zweiten Verbindungseinrichtung ein Innengewinde auf.

Weiterhin dargestellt ist ein Lastanschlusselement (60) das in einem Abschnitt (600) benachbart zur zweiten Verbindungseinrichtung (72) eine durchgehende, vorzugsweise langlochartige Ausnehmung (602) aufweist, die mit dem Innenzylinder (720) des zugeordneten Druckgussformteils (72) der zweiten Verbindungseinrichtung derart fluchtend angeordnet ist, dass eine Schraubverbindung einer externen Stromleitung mit der Verbindungseinrichtung und dem dazwischen angeordneten Kontaktelement der Stromleitung erreicht wird.

## Patentansprüche

1. Leistungshalbleitermodul (1) mit einem Gehäuse (10) mit ersten Verbindungseinrichtungen (70) zur Anordnung auf einem externen Kühlbauteil, mindestens einem Substratträger (40) mit einer hierauf ausgebildeten leistungselektronischen Schaltungsanordnungen (50) und von dieser ausgehenden elektrischen Anschlusselementen (60) zu zweiten Verbindungseinrichtungen (72) zur Verbindung mit externen Stromleitungen,
wobei die ersten und / oder die zweiten Verbindungseinrichtungen (70, 72) ausgebildet sind als im wesentlichen hohlzylinderförmige metallische Druckgussformteile, die spritztechnisch mit dem Gehäuse (10) verbunden sind.

2. Leistungshalbleitermodul nach Anspruch 1,
wobei der Substratträger (40) in einer Aussparung (12) des Gehäuses (10) angeordnet und von dem Gehäuse (10) seitlich umschlossen ist.

3. Leistungshalbleitermodul nach Anspruch 1,
wobei zumindest ein Anschlusselement (60) ein in Stanz-Biegetechnik ausgebildeter Metallformkörper ist.

4. Leistungshalbleitermodul nach Anspruch 1,
wobei das jeweilige Druckgussformteil (70, 72) aus Aluminium- oder Zinkdruckguss besteht.

5. Leistungshalbleitermodul nach Anspruch 1,
wobei das jeweilige Druckgussformteil (70, 72) an seinem Außenzylinder (702, 722) Fortsätze (704, 724) aufweist, die zur spritztechnischen Verbindung mit dem Kunststoff des Gehäuses (10) geeignet sind.

6. Leistungshalbleitermodul nach Anspruch 5,
wobei diese Fortsätze (704) rotationssymmetrisch um die Hochachse des Außenzylinders (700) des Druckgussformteils (70) ausgebildet sind.

7. Leistungshalbleitermodul nach Anspruch 5,
wobei diese Fortsätze (724) als einzelne Nasen um die Hochachse des Außenzylinders (722) des Druckgussformteils (72) ausgebildet sind.

8. Leistungshalbleitermodul nach Anspruch 1,
wobei das Druckgussformteil (70) der ersten Verbindungseinrichtung an seinem Innenzylinder (700) eine glatte Oberfläche aufweist.

9. Leistungshalbleitermodul nach Anspruch 1,
wobei das Druckgussformteil der zweiten Verbindungseinrichtung an seinem Innenzylinder (720) ein Innengewinde aufweist.

10. Leistungshalbleitermodul nach Anspruch 8,
wobei mindestens ein Lastanschlusselement (60) in einem Abschnitt (600) eine durchgehende Ausnehmung (602) aufweist und diese mit dem Innenzylinder (720) des zugeordneten Druckgussformteils (72) der zweiten Verbindungseinrichtung (72) fluchtend angeordnet ist.
